# EUROPEAN PATENT SPECIFICATION

(11) **EP 0 450 228 B1**
(45) Date of publication and mention of the grant of the patent: **21.06.1995**
(21) Application number: 90311837.0
(22) Date of filing: 29.10.1990
(51) Int. Cl.: H01L 29/267, H01L 21/205

(54) **Semiconductor device formed on a silicon substrate or a silicon layer and methods of making the same**
Halbleiteranordnung, die auf einem Siliziumsubstrat oder auf einer Siliziumschicht gebildet wird, und Verfahren zu deren Herstellung
Dispositif semi-conducteur formé sur un substrat en silicium ou sur une couche de silicium et méthodes de fabrication

(30) Priority: 30.03.1990 JP 86715/90
(43) Date of publication of application: 09.10.1991
(73) Proprietor: MITSUBISHI DENKI KABUSHIKI KAISHA, Tokyo (JP)
(72) Inventor: Nishimura, Takashi, c/o Mitsubishi Denki K. K., Itami-shi, Hyogo-ken (JP)
(74) Representative: Beresford, Keith Denis Lewis

(56) References cited:
- EP-A- 0 177 903
- EP-A- 0 365 875
- JOURNAL OF APPLIED PHYSICS, vol. 60, no. 5, September 1986, pages 1640-1647,American Institute of Physics, New York, US; R. FISCHER et al.: "Material properties of high-quality GaAs epitaxial layers grown on Si substrates"
- PATENT ABSTRACTS OF JAPAN, vol. 14, no. 431 (C-759)[4374], 17th September 1990 & JP-A-2 167 895
- S. M. Sze, "Physics of Semiconductor Devices," J. Wiley & Sons, New York, 1981, pages 347 - 349.

## Description

### FIELD OF THE INVENTION

The present invention relates to a semiconductor device and, more particularly, to a semiconductor device formed on an Si substrate or an Si layer. It also concerns a method of manufacturing a semiconductor device.

### BACKGROUND OF THE ART

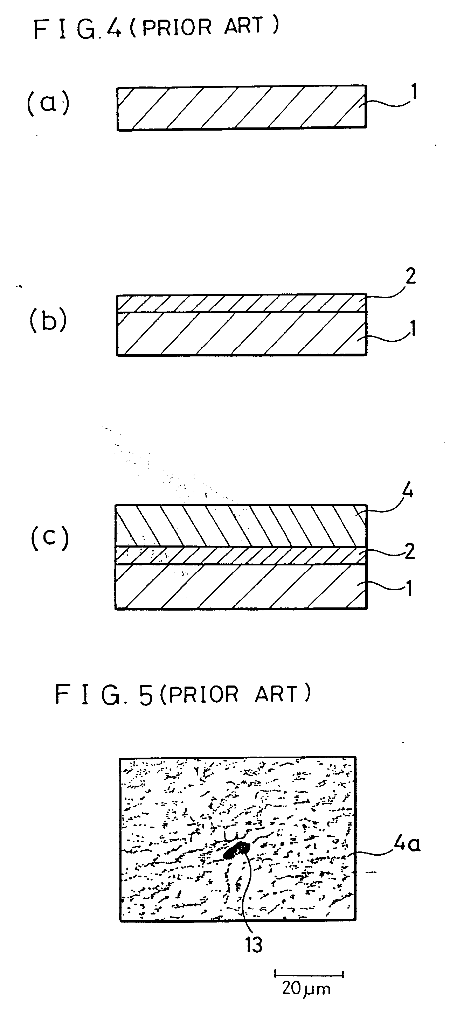

Figure 4 are sectional views showing main steps for forming a GaAs (gallium arsenide) layer on a Si substrate, which is disclosed in, for example Japanese Journal of Applied Physics Vol. 25 September, 1986, 1789 - 1791 "Effects of the Substrate Offset Angle on the Growth of GaAs on Si substrate".

In figure 4, reference numeral 1 designates a Si substrate having surface orientation, which has an off angle of several degrees from (100) surface toward <011> direction, reference numeral 2 designates a GaAs layer grown at low temperature (400°C), reference numeral 4 designates a GaAs layer grown at high temperature (700°C).

Next, a method for manufacturing those will be described in detail.

First, a surface of the Si substrate 1 is cleaned in a hydrogen (H₂) atmosphere at 900°C or more (figure 4(a)). Then, the Si substrate 1 is cooled and a GaAs layer is grown thereon at approximately 400°C by an MOCVD method until a thickness thereof 10nm (100Å) (figure 4(b)). Thereafter, the Si substrate 1 is heated up at 700°C and then the GaAs layer 4 is grown until a thickness thereof becomes 2 microns by the MOCVD method on the GaAs layer 2 which has been grown at low temperature (figure 4(c)).

However, in a case where a crystal is grown on different kinds of substrates, typical of a case where the GaAs layer is formed on the Si substrate, three-dimensional growth of GaAs is likely to occur because misfitting stress is generated by a difference in lattice constant of Si and GaAs or surface orientation dependency. If the GaAs layer is grown at low temperature (∼400°C), a crystal quality is low but it is possible to prevent generation of three-dimensional crystal which is likely to occur because surface orientation dependency of the crystal growth or misfitting stress is generated by a difference in the lattice constant. More specifically, at low temperature, a crystal is grown under the condition of chemical non-equilibrium, surface orientation dependency or three- dimensional crystal is not likely to be generated, so that the plane two-dimensional GaAs crystal 2 can be easily obtained. Therefore, it is possible to form the GaAs layer 4 of high quality having good coverage by forming the thin GaAs layer 2 at low temperature first to flatten the surface of the Si substrate and then forming the GaAs layer at high temperature.

As described above, in the conventional method for growing the GaAs layer on the Si substrate, means for forming the plane GaAs layer 4 on the Si substrate is provided. However, abnormal growth of GaAs is not effectively prevented as shown in figure 5 (reference photograph is to be referred), in which there is abnormal growth of GaAs in (100) surface of the GaAs crystal. In figure 5, reference numeral 4a designates (100) surface of the GaAs layer 4 and reference numeral 13 designates a pit around which there is abnormal growth of GaAs.

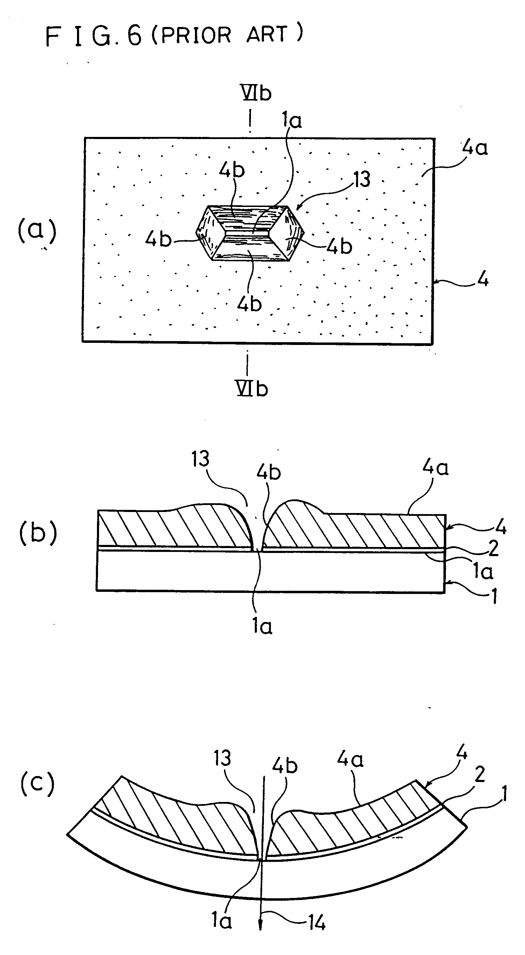

Thus, when there is dust or other defects (pit) on the Si substrate 1, GaAs is abnormally grown around that. Figure 6(a) is a plan view showing abnormal growth of GaAs around a defect of the Si substrate surface just after GaAs are sequentially grown at low and high temperature on the Si substrate 1 and Figure 6(b) is a sectional view taken along a line VIb - VIb of figure 6(a). In figure 6, the same references as in figure 4 designate the same parts. Reference numeral 4a designates (100) surface of the GaAs layer 4 grown at high temperature, reference numeral 4b designates (111) surface of the GaAs layer 4 grown at high temperature, reference numeral 13 designates a pit and reference numeral 1a designates an exposed Si (100) surface. As shown in figure 6, the GaAs layer 4a of (100) surface is grown on the Si substrate which has off angle of several degrees from the (100) surface to <011> direction. However, if there is a defect on the Si surface, GaAs is not likely to be grown at that defect part and the GaAs (111) surface 4b is actively grown around that defect, with the result that a trench 13 surrounded by the abnormally grown GaAs (111) surface is formed.

In addition, when the GaAs layer is formed on the Si substrate, since a thermal expansion coefficient of GaAs is more than twice as many as that of Si (Si ; 2.4 X 10⁻⁶ [K⁻¹], GaAs ; 5.7 X 10⁻⁶ [K⁻¹]), thermal stress of approximately 1x10⁸∼2x10⁸Pa [1x10⁹∼2x10⁹ dyn ^{.} cm⁻²] remains in the GaAs layer, causing the substrate to be curved. In addition, intensity of this stress is very close to anti-rupture strength of the GaAs layer 4 and when this thermal stress converges around the swell generated by abnormal growth of GaAs, a crack is likely to be generated in the GaAs layer. As a result, performance or yield of the semiconductor device is considerably lowered. Figure 6(c) shows a curved substrate, in which a crack 14 is generated in the pit 13 because of the difference between the thermal expansion coefficients of Si and GaAs. At this time, temperature has dropped from that in figure 6(b) after a while. Therefore, it is necessary to set the thickness of the GaAs layer 4 at 3.0 »m or less to prevent the remaining thermal stress in the GaAs layer from converging at the pit 13 on the GaAs substrate surface and the crack from being generated.

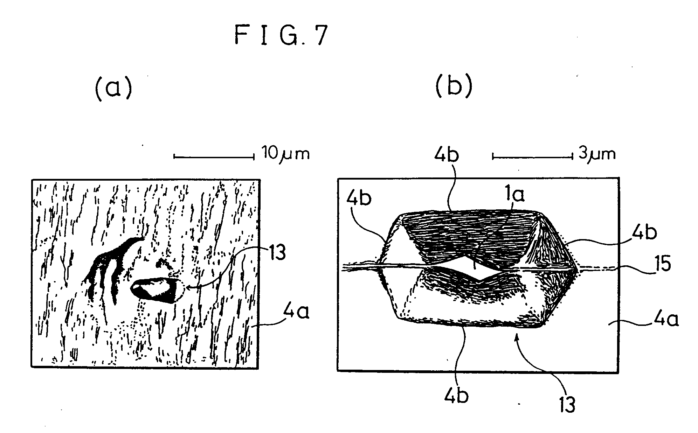

Figure 7(a) and (b) show the swell generated by abnormal growth of GaAs around the surface defect of the Si substrate and the crack generated at that abnormal grown part in crystal photographs (reference photographs are to be referred to), in which the same reference numerals as in figure 6 designate the same parts. As shown in figure 7, it is found that crack 15 is generated through the pit 13 of the GaAs layer.

Reference is made to an article entitled "Material properties of high quality GaAs epitaxial layers grown on Si substrates" by R. Fischer et al, Journal of Applied Physics, Vol.60, No.5, pages 1640-1647 (1986) Sept., which discloses the growth of GaAs layers over Si substrates by forming a prelayer of As or Ga on the Si substrate; forming a GaAs/AlAs superlattice on the prelayer; forming a strained-layer GaAs/InGaAs superlattice on the first superlattice; and forming a GaAs layer (cf. sections II and IIIB). In particular, the strained-layer superlattice has the purpose of preventing dislocations from propagating up towards the GaAs layer. The problem that pitting (macroscopic surface defects) can occur as a result of abnormal growth, and that cracks can propagate due to stress concentration about such pitting is neither addressed nor resolved.

### SUMMARY OF THE INVENTION

The present invention is intended as solution to the problems aforesaid and it is an object of the present invention to provide a semiconductor device having a semiconductor layer formed on an Si surface, in which there is no swell generated when a semiconductor layer (e.g. GaAs) is grown, surface defects are reduced and no crack is generated even when the thickness of the semiconductor layer exceeds 5 »m.

A semiconductor device and a method of manufacturing a semiconductor device, each in accordance with the present invention, are defined in appended claims 1 and 8, respectively.

Since thin films of AlAs and GaAs (preferably of total thickness 70 nm (700Å) or less) are formed first on the Si substrate in the semiconductor device before the semiconductor layer is formed, there is no abnormal growth of the semiconductor layer generated on the surface and surface defects are reduced. As a result, performance and yield of the semiconductor device is improved and crack generation is prevented.

### BRIEF DESCRIPTION OF THE DRAWINGS

Figure 1 are sectional views showing process for forming semiconductor layers on Si in a semiconductor device in accordance with an embodiment of the present invention;
Figure 2 is a view of a photograph showing a surface of a GaAs crystal formed on an Si crystal in the semiconductor device in accordance with an embodiment of the present invention;
Figure 3 are views showing an element formed on the Si crystal and an element formed on a compound semiconductor layer which are made monolithic in accordance with an embodiment of the present invention;
Figure 4 are views showing conventional process for forming semiconductor layers on Si in a semiconductor device;
Figure 5 is a view of a photograph showing a surface of a GaAs crystal formed on an Si crystal in the prior art;
Figure 6 are views used in describing problems in the prior art; and
Figure 7 are views of photographs of crystals showing swell generated by abnormal growth of GaAs layer formed on the Si crystal and crack generated at that abnormally grown part.

### DETAILED DESCRIPTION OF PREFERRED EMBODIMENT

An embodiment of the present invention will be described in detail with reference to the drawings.

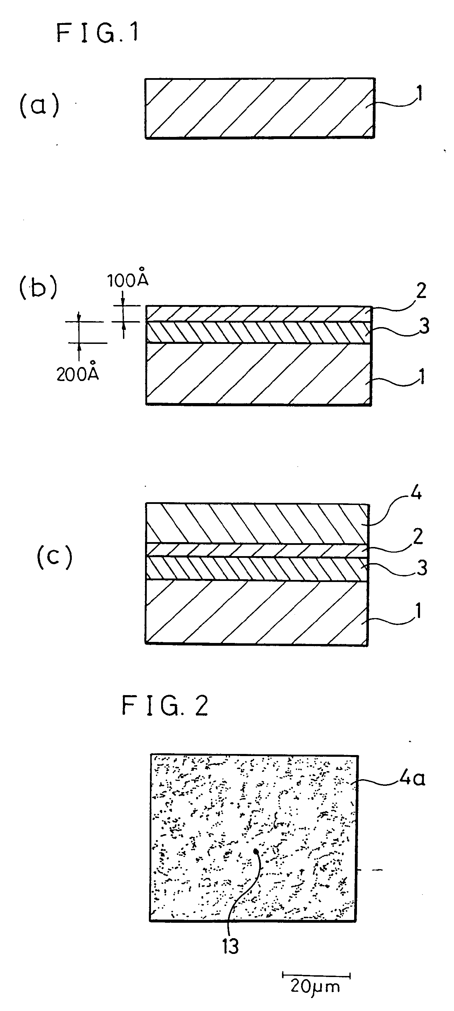

Figure 1 are sectional views each showing a semiconductor device at each main manufacturing step in accordance with an embodiment of the present invention. In figure 1, reference numeral 1 designates an Si substrate having surface orientation which has an off angle of several degrees from (100) surface to <011> direction, reference numeral 2 designates a GaAs layer grown at low temperature, reference numeral 3 designates an AlAs layer grown at low temperature and reference numeral 4 designates a GaAs layer grown at high temperature.

Then, operation thereof will be described hereinafter.

First, a surface of the Si substrate 1 is cleaned in a hydrogen (H₂) atmosphere at 900°C or more (figure 1 (a)) and then the substrate 1 is cooled and then a AlAs layer 3 having a thickness of 20 nm (200Å) is formed thereonat approximately 400°C by an MOCVD method. Then, a GaAs layer 2 having a thickness of 10 nm (100Å) is formed thereon under the same condition as above (figure 1(b)).

Thereafter, the substrate 1 is heated up at 700°C and a GaAs layer 4 having a thickness of 2 »m is formed by the MOCVD method (figure 1(c)).

As described in the conventional example, in the case where the GaAs layer is formed on different kinds of substrates, typical of the case where GaAs is formed on the Si substrate, the GaAs layer grown at low temperature (∼ 400°C) prevents generation of the surface orientation dependency of the crystal growth and three-dimensional crystal which occurs because misfitting stress is generated by a difference in the lattice constant. More specifically, since the crystal is grown in the state of chemical non-equilibrium at low temperature, dependency of surface orientation or three-dimensional crystal is not likely to be generated, whereby a plane crystal can be easily obtained.

The reason why the AlAs layer 3 is grown first on the Si substrate 1 before the GaAs layer 2 is grown at low temperature is that bonding force between AlAs and Si is stronger than that between GaAs and Si, that is, the bonding force between an Al atom and an Si atom is stronger than that between a Ga atom and the Si atom. Therefore, three-dimensional crystal is not likely to be grown in a case where the AlAs crystal is grown on the Si substrate as compared with a case where the GaAs crystal is grown and then the surface of the Si crystal can be more flatly covered.

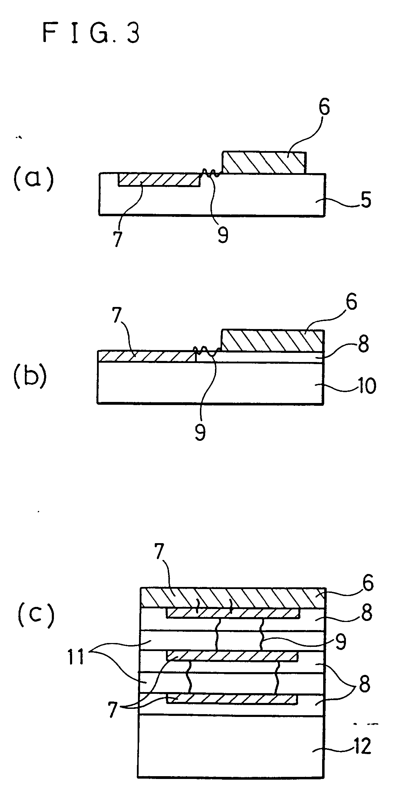

Figure 2 is a view of a photograph showing (100) surface of the GaAs layer 4 on the Si substrate. As shown in figure 2, there is a small pit 13 in the centre thereof but there is no abnormal swell around the pit which is seen in figure 5.

As described above, since adhesion between the AlAs layer and the Si substrate is better than that between the GaAs layer and the Si substrate, the layer oan be well flattened. Therefore, surface defects can be reduced to a certain degree merely by changing the GaAs layer grown at low temperature by the conventional method to this AlAs layer, which will be described later. However, when the GaAs layer 4 is grown on the AlAs layer after the temperature thereof is increased to high temperature (∼700°C), a slight lattice mismatch exists (∼0.2%) between the GaAs layer and the AlAs layer, with the result that abnormal growth is likely to occur because three-dimensional crystal is generated by misfitting stress which especially converges around the surface defect. Thus, in order to provide the GaAs layer 4 with less defect, it is necessary to use homo-epitaxial growth in which the AlAs layer 3 and the GaAs layer 2 are both grown at low temperature before the GaAs layer 4 is grown at high temperature and then the GaAs layer 4 is grown on the GaAs layer 2. Another reason for GaAs layer 2 is that AlAs is very sensitive to residual oxygen in the reactor and also apt to cause surface defects during the high temperature GaAs growth. As a result, surface defects of the GaAs layer 4 can be fairly reduced by this method as compared with the case where the GaAs layer 4 is formed at high temperature through the AlAs layer 3 which has been grown on the Si substrate at low temperature.

In order to describe an effect of the present invention as compared with that in the conventional example, a semiconductor layer is grown on the Si substrate by the following three kinds of methods and then the number of pits within a range of 8 cm (3 inches) of wafer on the surface of each semiconductor layer was classified by a particle size thereof and counted. The results are shown in the following tables 1 to 3.

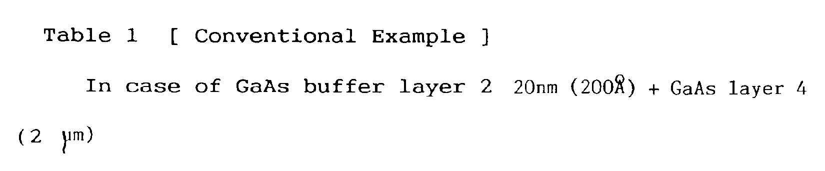

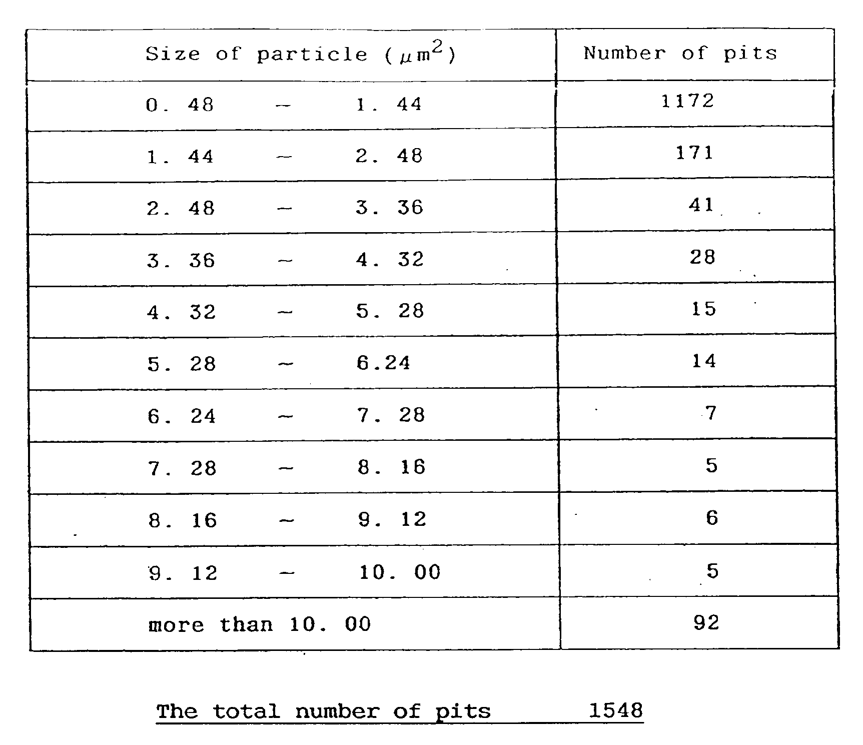

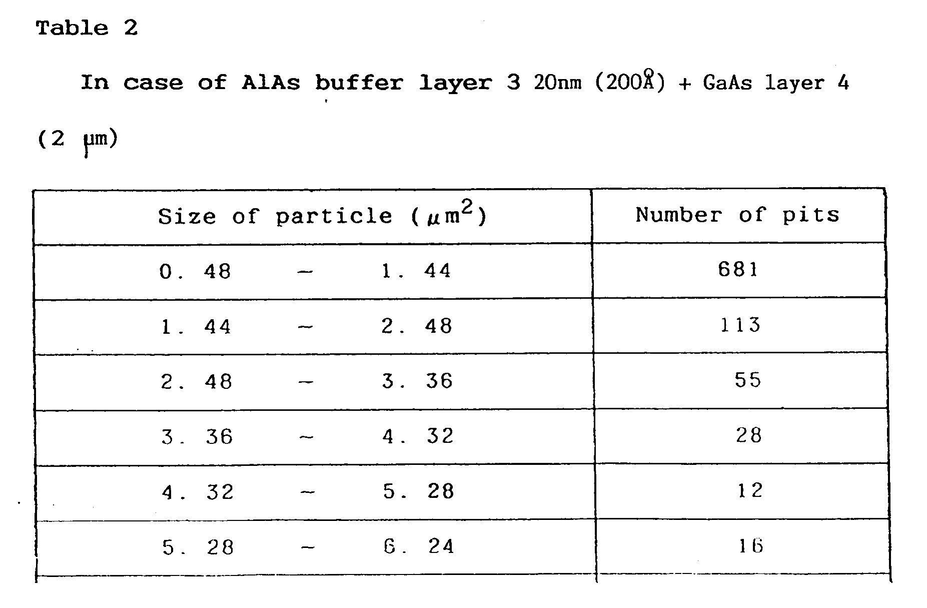

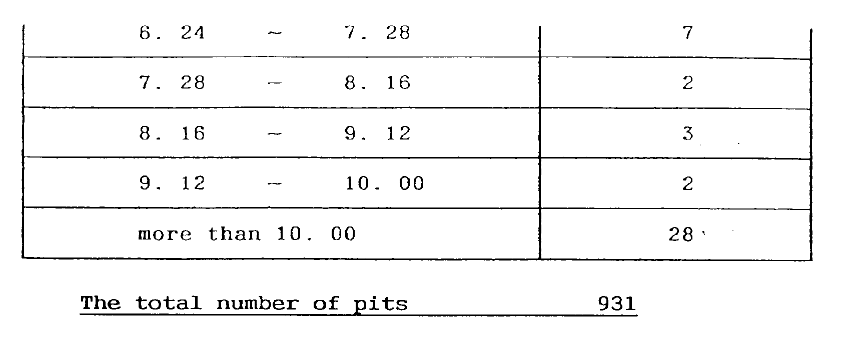

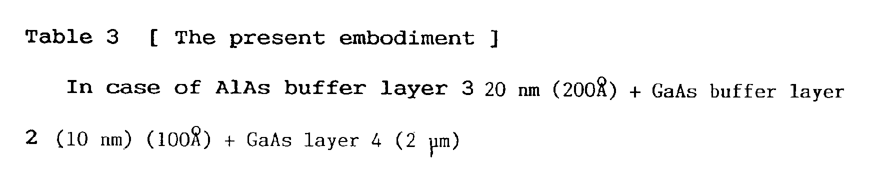

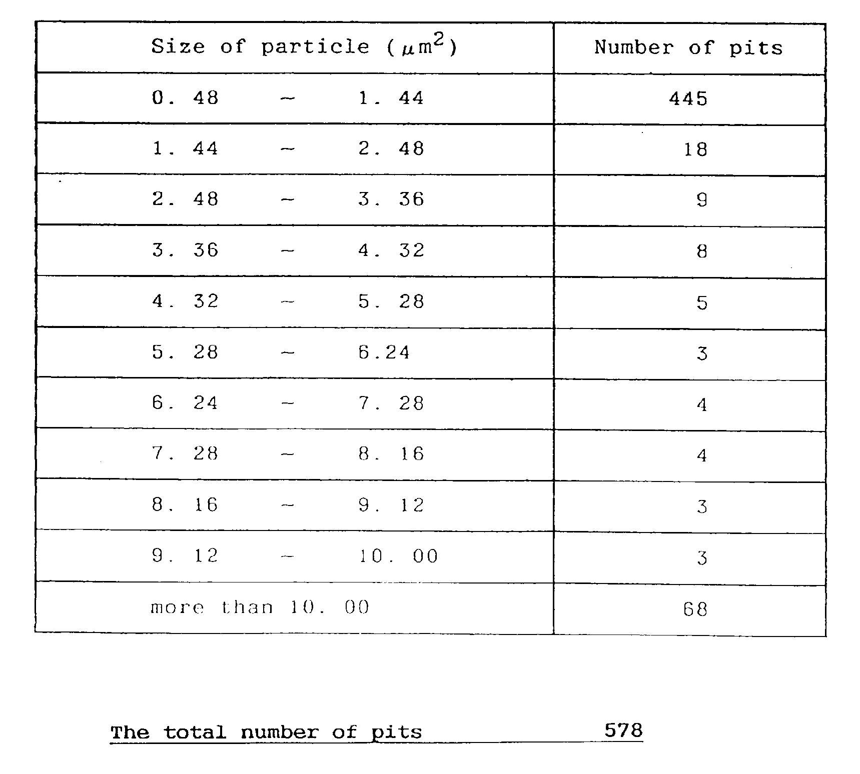

As can be seen from histograms of pits in the above tables 1 to 3, there are 1548 pits within 8 cm (3 inches) of the wafer in the prior art as shown in table 1, while the number of pits is considerably reduced to 571 because the AlAs layer is introduced . This number is almost one third of the above and also the size of particles is relatively reduced.

In addition, as shown in the table 2, the number of pits are 931 in the case where the GaAs layer 4 is formed on the Si substrate through only the AlAs layer 3 by hetero-epitaxial growth, which number is considerably larger than that in the case where the GaAs layer 4 is grown through the AlAs layer 3 and the GaAs layer 2. This is because of mismatch of lattice constants of the GaAs layer 4 and the AlAs layer 2 as described above. Therefore, it is found that it is better to form the GaAs layer 4 by homo-epitaxial growth.

As described above, since the AlAs layer 3 and the GaAs layer 2 are sequentially grown at low temperature until they are 30nm (300Å) in thickness and then the GaAs layer 4 is formed at high temperature thereon, it is possible to prevent abnormal growth of the GaAs layer 4 caused by dust, a defect or the like on the Si substrate 1, with the result that the number of surface thickness of the GaAs layer 4 is 5 »m or more, there is no crack generated when the GaAs layer serving as the semiconductor layer 4 is grown on the Si substrate. This is because the number of surface defects is considerably reduced and the size thereof is also reduced.

Although the AlAs layer 3 is 20nm (200Å) in thickness and the GaAs layer 2 is 10nm (100Å) in thickness in the above embodiment, these are not limited to these values and the same effect can be attained if only each of these are 5nm (50Å) or more and the total thickness thereof is 70nm (700Å) or less.

In addition, although the GaAs layer 4 is grown after the temperature is increased to 700°C in the above embodiment, the material of the layer is not limited to GaAs and it may be another compound semiconductor such as AlGaAs, InP, InGaAs or InGaAsP. In case of InP or the like, it is also possible to start grow it at low temperature of approximately 400°C after the temperature of the substrate 1 is increased to 700°C and then decreased.

In an embodiment a LSI formed on the Si crystal is connected to an optical device and the microwave device formed on the GaAs or InP crystal by a wire and then a monolithic integrated circuit can be implemented. At this time, the Si crystal may be on an Si substrate or an Si thin film on an insulating substrate such as sapphire. Figure 3 (a) to (c) show several examples of structures in which that monolithic integrated circuit is implemented. In figure 3 reference numeral 5 designates an Si substrate, reference numeral 6 designates a GaAs group microwave IC or an InP group optical device, reference numeral 7 designates an Si-LSI, reference numeral 8 designates a thin film, reference numeral 9 designates a wire for connecting the IC 6 to the Si-LSI 7, reference numeral 10 designates a sapphire substrate, reference numeral 11 designates an insulating film and reference numeral 12 designates a substrate formed of sapphire, Si or the like.

In figure 3(a), the LSI 7 is formed on the Si substrate 5 and the GaAs group microwave IC or InP group optical device 6 is formed on the GaAs layer formed on the Si substrate 5 and then the LSI 7 is connected to the microwave IC or the optical device 6 by the wire 9. In figure 3(b), the Si thin film 8 is formed on the sapphire substrate 10 instead of the Si substrate 5. In figure 3(c), a three-dimensional device such as Si - oxide film - Si is formed in such a manner that the Si thin film is formed on the substrate 12 formed of sapphire, Si or the like, the LSI 7 is formed on the Si thin film, the Si-LSI 7 is formed thereon through the insulating film, which operation is repeated two times, the GaAs layer is formed on the Si film 8, the GaAs group microwave IC or InP group optical device 6 is formed therein and then the Si-LSI 7 in each layer is connected to the GaAs group microwave IC or InP group optical device 6 by the wiring 9 provided in a through hole or the like.

Thus, when the LSI formed on the Si substrate and the optical device, microwave device or the like formed in the compound semiconductor layer on the Si substrate are made monolithic, there is no crack generated, with the result that the semiconductor device can be formed with high precision and yield and performance thereof can be fairly improved.

Since the AlAs and the GaAs thin layers are formed between the Si substrate and the semiconductor layer, abnormal growth of the semiconductor layer generated by dust on the Si substrate or the like is prevented and the number of surface defects is considerably reduced. As a result, even when a film thickness of the semiconductor layer is 5 »m or more, there is no crack generated therein, so that it is possible to provide a reliable semiconductor device with high yield.

## Claims

1. A semiconductor device having a semiconductor layer (4) or a plurality of semiconductor layers formed of a material other than Si on a Si substrate (1) or Si layer comprising:
an AlAs (aluminium arsenide) thin layer (3) and a GaAs (gallium arsenide) thin layer (2) provided between said Si substrate (1) or Si layer and said semiconductor layer (4), with said AlAs thin layer (3) being located directly upon the surface of said Si substrate (1) or Si layer.

2. A semiconductor device in accordance with claim 1, wherein said AlAs layer (3) and said GaAs layer (2) formed between said Si layer or Si substrate (1) and said semiconductor layer (4) are each 5 nm (50Å) or more in thickness and the total of their thickness is not more than 70 nm (700Å).

3. A semiconductor device in accordance with claim 1, wherein said semiconductor layer (4) formed on the Si substrate (1) or Si layer is a GaAs layer (4) and thin films (3,2) formed of AlAs and GaAs are provided between said Si substrate (1) or Si layer and said GaAs semiconductor layer (4).

4. A semiconductor device in accordance with both claims 2 and 3, wherein said AlAs layer (3) is 20 nm (200Å) in thickness, said GaAs layer (2) is 10 nm (100Å) in thickness and said GaAs semiconductor layer (4) is 2 »m in thickness.

5. A semiconductor device in accordance with claim 1, wherein said semiconductor layer (4) is formed of GaAs, AlGaAs, InP, InGaAs or InGaAsP compound semiconductor.

6. A semiconductor device in accordance with claim 1, wherein said Si layer is formed on a sapphire substrate.

7. A semiconductor device as claimed in any one of the preceding claims, wherein an optical or microwave component is defined in said semiconductor layer (4), and an integrated circuit, connected to said component, is defined in said silicon substrate (1) or layer.

8. A method of manufacturing a semiconductor device, wherein a semiconductor layer (4) of material other than silicon is grown over a silicon substrate (1) or layer, characterised by:
growing a thin-film layer (3) of aluminium arsenide, epitaxially and at a relatively low temperature, directly on a surface of said silicon substrate or layer;
growing a thin-film layer (2) of gallium arsenide, epitaxially and at a relatively low temperature, directly on the surface of said thin-film layer (3) of aluminium arsenide; and
growing said semiconductor layer (4), epitaxially and at a higher temperature, directly on the surface of said thin film (2) of gallium arsenide.

9. A method as claimed in claim 8 wherein:
said semiconductor layer (4) is of gallium arsenide;
said thin film layers (3,2) of aluminium arsenide and gallium arsenide are each grown by organo-metallic chemical vapour deposition (MOCVD) at a temperature of 400°C; and
said semiconductor layer (4) is grown by organo-metallic chemical vapour deposition (MOCVD) at a temperature of 700°C.

## Patentansprüche

1. Eine Halbleitervorrichtung mit einer Halbleiterschicht (4) oder einer Vielzahl von Halbleiterschichten, die aus einem anderen Material als Si auf einem Si-Substrat (1) oder einer Si-Schicht gebildet sind, mit:
einer dünnen Schicht (3) AlAs (Aluminiumarsenid) und einer dünnen Schicht (2) GaAs (Galliumarsenid), die zwischen dem Si-Substrat (1) oder der Si-Schicht und der Halbleiterschicht (4) bereitgestellt sind, wobei die dünne AlAs-Schicht (3) sich direkt auf der Oberfläche des Si-Substrats (1) oder der Si-Schicht befindet.

2. Eine Halbleitervorrichtung nach Anspruch 1, worin die AlAs-Schicht (3) und die GaAs-Schicht (2), die zwischen der Si-Schicht oder dem Si-Substrat (1) und der Halbleiterschicht (4) ausgebildet sind, jede 5 nm (50 Å) oder mehr dick sind und ihre gesamte Dicke nicht mehr als 70 nm (700 Å) beträgt.

3. Eine Halbleitervorrichtung nach Anspruch 1, worin die auf dem Si-Substrat (1) oder der Si-Schicht ausgebildete Halbleiterschicht (4) eine GaAs-Schicht (4) ist und dünne Schichten (3, 2) aus AlAs und GaAs zwischen dem Si-Substrat (1) oder der Si-Schicht und der GaAs-Halbleiterschicht (4) bereitgestellt sind.

4. Eine Halbleitervorrichtung nach sowohl Anspruch 2 als auch 3, worin die AlAs-Schicht (3) 20 nm (200 Å) dick ist, die GaAs-Schicht (2) 10 nm (100 Å) dick ist und die GaAs-Halbleiterschicht (4) 2 »m dick ist.

5. Eine Halbleitervorrichtung nach Anspruch 1, worin die Halbleiterschicht (4) aus einem GaAs-, AlGaAs-, InP-, InGaAs- oder InGaAsP-Verbindungshalbleiter gebildet ist.

6. Eine Halbleitervorrichtung nach Anspruch 1, worin die Si-Schicht auf einem Saphirsubstrat ausgebildet ist.

7. Eine Halbleitervorrichtung wie in einem der vorigen Ansprüche beansprucht, worin eine optische oder Mikrowellenkomponente in der Halbleiterschicht (4) definiert ist, und eine integrierte Schaltung, die mit dieser Komponente verbunden ist, in dem Siliziumsubstrat (1) oder der Siliziumschicht definiert ist.

8. Ein Verfahren zum Herstellen einer Halbleitervorrichtung, worin eine Halbleiterschicht (4) aus einem anderen Material als Silizium über einem Siliziumsubstrat (1) oder einer Siliziumschicht aufgewachsen ist, gekennzeichnet durch:
Aufwachsen, epitaktisch und bei einer relativ niedrigen Temperatur, einer Dünnfilm-Schicht (3) von Aluminiumarsenid direkt auf einer Oberfläche des Siliziumsubstrats oder der Siliziumschicht;
Aufwachsen, epitaktisch und bei einer relativ niedrigen Temperatur, einer Dünnfilm-Schicht (2) von Galliumarsenid direkt auf der Oberfläche der Dünnfilm-Schicht (3) von Aluminiumarsenid; und
Aufwachsen, epitaktisch und bei einer höheren Temperatur, der Halbleiterschicht (4) direkt auf der Oberfläche des dünnen Films (2) von Galliumarsenid.

9. Ein Verfahren wie in Anspruch 8 beansprucht, worin:
die Halbleiterschicht (4) aus Galliumarsenid besteht;
die dünnen Schichten (3, 2) aus Aluminiumarsenid und Galliumarsenid jede durch organo-metallische chemische Abscheidung aus der Gasphase (MOCVD) bei einer Temperatur von 400°C aufgewachsen werden; und
die Halbleiterschicht (4) durch organo-metallische chemische Abscheidung aus der Gasphase (MOCVD) bei einer Temperatur von 700°C aufgewachsen wird.

## Revendications

1. Dispositif semi-conducteur ayant une couche (4) semi-conductrice ou une pluralité de couches semi-conductrices formées d'un matériau différent de Si sur un substrat en Si (1) ou une couche de Si comprenant :
une fine couche (3) de AlAs (arseniure d'aluminium) et une couche fine (2) de GaAs (arseniure de gallium) prévues entre ledit substrat en Si (1) ou ladite couche en Si et ladite couche semi-conductrice (4), avec ladite couche fine (3) de AlAs étant située directement sur la surface dudit substrat en Si (1) ou couche en Si.

2. Dispositif semi-conducteur selon la revendication 1, dans lequel la couche de AlAs (3) et la couche de GaAs (2) formées entre ladite couche de Si ou ledit substrat en Si (1) et ladite couche semi-conductrice (4) sont chacune de 5 nm (50Å) ou plus d'épaisseur et que le total de leur épaisseur n'est pas supérieur à 70 nm (700Å).

3. Dispositif semi-conducteur selon la revendication 1, dans lequel ladite couche semi-conductrice (4) formée sur le substrat en Si (1) ou la couche en Si est une couche de GaAs (4) et les films fins (3, 2) formés d' AlAs et GaAs sont prévus entre ledit substrat en Si (1) ou ladite couche en Si et ladite couche semi-conductrice en GaAs (4).

4. Dispositif semi-conducteur selon les revendications 2 et 3, dans lequel ladite couche de AlAs (3) est de 20 nm (200Å) d'épaisseur, ladite couche de GaAs (2) est de 10 nm (100Å) d'épaisseur et ladite couche semi-conductrice de GaAs (4) est de 2 »m d'épaisseur.

5. Dispositif semi-conducteur selon la revendication 1, dans lequel la couche semi-conductrice (4) est formée d'un composé semi-conducteur de GaAs, AlGaAs, InP, InGaAs ou InGaAsP.

6. Dispositif semi-conducteur selon la revendication 1, dans lequel ladite couche de Si est formée sur un substrat en saphir.

7. Dispositif semi-conducteur selon l'une quelconque des revendications précédentes, dans lequel un composant de micro-ondes est défini dans ladite couche semi-conductrice (4) et un circuit intégré, connecté audit composant, est défini dans ledit substrat ou couche en silicium (1).

8. Méthode de fabrication d'un dispositif semi-conducteur, dans laquelle une couche semi-conductrice (4) d'un matériau différent du silicium est mise à croître sur un substrat ou couche en silicium (1), caractérisée par :
la croissance d'une couche en film fin (2) d'arseniure d'aluminium, épitaxialement et à une température relativement basse, directement sur la surface dudit substrat ou couche en silicium ;
la croissance d'une couche en film fin (2) d'arseniure de gallium, épitaxialement et à une température relativement basse, directement sur la surface de ladite couche en film fin (3) d'arseniure d'aluminium ; et
la croissance de ladite couche semi-conductrice (4), épitaxialement et à une température plus élevée, directement sur la surface dudit film fin (2) d'arseniure de gallium.

9. Méthode selon la revendication 8, dans laquelle :
ladite couche semi-conductrice (4) est en arseniure de gallium ;
lesdites couches en film fin (3, 2) d'arseniure d'aluminium et d'arseniure de gallium sont chacune mises à croître par une méthode de dépôt en phase vapeur chimique organo-métallique (MOCVD) à une température de 400°C ; et
ladite couche semi-conductrice (4) est mise à croître par une méthode de dépôt en phase vapeur chimique organométallique (MOCVD) à une température de 700°C.
